# EUROPEAN PATENT APPLICATION

(11) **EP 2 453 455 A1**
(43) Date of publication of application: **16.05.2012**
(21) Application number: 11188709.7
(22) Date of filing: 10.11.2011
(51) Int. Cl.: H01G 9/20

(54) **Sealing member for photoelectric conversion device, photoelectric conversion device having the same and method of preparing the same**

(30) Priority: 12.11.2010 KR 20100112722
(71) Applicant: Samsung SDI Co., Ltd., Yongin-si, Gyeonggi-do (KR)
(72) Inventor: Lee, Seung-Hwan, YONGIN-SI- Gyeonggi-do (KR); Lim, Jae-Seok, YONGIN-SI- Gyeonggi-do (KR); Hwang, Soon-Hak, YONGIN-SI- Gyeonggi-do (KR); Song, Jung-Suk, YONGIN-SI- Gyeonggi-do (KR)
(74) Representative: Kurtz, Laurent Charles Edmond

(57) **Abstract**

A sealing member, a photoelectric conversion device having the same, and a method of preparing the same are disclosed. In one aspect, the sealing member (9) for the photoelectric conversion device joins a first substrate and a second substrate, which face each other, and seals an electrolyte solution in a space therebetween. An edge (XY1, XY2, YX1, YX2)of the sealing member includes a rounded portion and a radius of a circle including the rounded portion is about 50% or more of the width of the sealing member. The sealing member may serve to reduce leakage of the electrolyte solution due to lowered adhesion of the sealing member or a wrinkled sealing member, and thus, improve reliability of the photoelectric conversion device.

## Description

### BACKGROUND

### Field of the Disclosure

The present disclosure relates to a sealing member for a photoelectric conversion device, a photoelectric conversion device having the same, and a method of preparing the same. The present disclosure also relates to a sealing member for a photoelectric conversion device having a modified shape to improve reliability of a product, a photoelectric conversion device having the same, and a method of preparing the same.

### Description of the Related Technology

A solar cell is an environmental-friendly energy source that includes a silicon solar cell or a dye-sensitized solar cell. Silicon solar cells are difficult to commercialize due to considerably high manufacturing costs. There are also difficulties in improving battery efficiency of silicon solar cells. In comparison to silicon solar cells, dye-sensitized solar cells have remarkably low manufacturing costs. Further, unlike silicon solar cells, dye-sensitized solar cells are photoelectrochemical solar cells mainly formed of dye molecules and transition metal oxides, which absorb visible rays to generate an electron-hole pair, and which transmit generated electrons, respectively.

To manufacture a dye-sensitized solar cell module, a sealing film is disposed between upper and lower substrates and is melted by applied heat and pressure for a predetermined time using a hot-press to join the upper and lower substrates. For a sealing film having a low melting point, however, the dye may be damaged by heat conducted through the upper and lower substrates by application of the hot-press. However, this sealing process may also cause solution to be leaked over time, and thus, decrease long-term reliability and electricity generation performance deteriorates. In contrast, using Bynel^{®} film, which has a comparatively high melting point, the dye may be damaged by heat conducted through the upper and lower substrates, and thus electric energy generation efficiency as a dye-sensitized solar cell is reduced.

### SUMMARY OF CERTAIN INVENTIVE ASPECTS

According to one aspect, a sealing member is provided for a photoelectric conversion device, which has a modified shape to improve reliability of a product.

In another aspect, a sealing member for a photoelectric conversion device joining a first substrate and a second substrate, facing each other, and sealing an electrolyte solution in a space therebetween is provided.

At least one edge of the sealing member includes a rounded portion, and a radius of a circle including the rounded portion is about 50% or more of the width of the sealing member. In some embodiments, a thickness of the sealing member is between about 50 µm and about 300 µm. In some embodiments, the sealing member is formed of a MAH-g-HDPE film (sold under the trademark Bynel). In some embodiments, the sealing member is formed of an ethylene / methacrylic acid copolymer film (sold under the name Siren).

In some embodiments, the rounded portion forms an outer arc (a) of circle and an inner arc of circle.

In another aspect, a photoelectric conversion device includes a first substrate and a second substrate facing each other and a sealing member as defined above, joining the first substrate to the second substrate and sealing an electrolyte solution in a space therebetween.

In another aspect, a method of preparing a photoelectric conversion device is provided. The method includes preparing a first substrate and a second substrate facing each other and joining the first substrate to the second substrate using a sealing member to seal an electrolyte solution in a space therebetween, the sealing member including at least one rounded edge region.

A radius of a circle including the rounded portion as part of the circle is about 50% or more of a width of the sealing member. In some embodiments, a thickness of the sealing member is between about 50 µm and about 300 µm. In some embodiments, the joining the first substrate to the second substrate includes, for example, disposing the sealing member between the first substrate and the second substrate and selectively irradiating a laser to the sealing member. In some embodiments, the laser irradiation is performed at a constant speed. In some embodiments, in the selectively irradiating the laser, uniform energy per unit area is applied by the irradiation in the rounded portion. In some embodiments, the joining of the first substrate to the second substrate is performed by selective laser irradiation to the sealing member. In some embodiments, the laser irradiation in the rounded portion is performed at a constant speed. In some embodiments, uniform energy per unit area is applied by the irradiation in the rounded portion. In some embodiments, the rounded portion forms an outer arc (a) of circle and an inner arc of circle.

### BRIEF DESCRIPTION OF THE DRAWINGS

Features of the present disclosure will become more fully apparent from the following description, taken in conjunction with the accompanying drawings. It will be understood these drawings depict only certain embodiments in accordance with the disclosure and, therefore, are not to be considered limiting of its scope; the disclosure will be described with additional specificity and detail through use of the accompanying drawings. An apparatus, system or method according to some of the described embodiments can have several aspects, no single one of which necessarily is solely responsible for the desirable attributes of the apparatus, system or method. After considering this discussion, and particularly after reading the section entitled "Detailed Description of Certain Inventive Embodiments" one will understand how illustrated features serve to explain certain principles of the present disclosure.

FIG. 1 is a cross-sectional view schematically illustrating a unit cell of a photoelectric conversion device according to an embodiment of the present disclosure.

FIG. 2 illustrates a dye connected to an inorganic metal oxide semiconductor.

FIG. 3A is a plan view schematically illustrating part of a photoelectric conversion device according to an embodiment of the present disclosure.

FIG. 3B is a plan view illustrating an enlarged XY2 portion of FIG. 3A.

FIGS. 4A and 4B show graphs illustrating a change of a speed in an edge of sealing members according to a Comparative example and an Example.

FIGS. 5A and 5B show graphs illustrating a change of energy concentrated on an edge of sealing members according to a Comparative example and an Example.

FIGS. 6A and 6B are photographs of sealing members according to a Comparative Example and the Example.

FIG. 7 is a flowchart illustrating a method of preparing a photoelectric conversion device according to an embodiment of the present disclosure.

### DETAILED DESCRIPTION OF CERTAIN INVENTIVE EMBODIMENTS

In the following detailed description, only certain exemplary embodiments of the present invention have been shown and described, simply by way of illustration. As those skilled in the art would realize, the described embodiments may be modified in various different ways, all without departing from the invention as claimed. Accordingly, the drawings and description are to be regarded as illustrative in nature and not restrictive. In addition, when an element is referred to as being "on" another element, it can be directly on the other element or be indirectly on the other element with one or more intervening elements interposed therebetween. Also, when an element is referred to as being "connected to" another element, it can be directly connected to the other element or be indirectly connected to the other element with one or more intervening elements interposed therebetween. Hereinafter, like reference numerals refer to like elements. Reference numerals followed by the " ' " sign may also correspond to elements not visible on the drawings but positioned symmetrically below the element bearing the same reference numeral but without the " ' " sign. Since the disclosure may be modified in various ways and have various embodiments, the disclosure will be described in detail with reference to the drawings. However, it should be understood that the disclosure is not limited to a specific embodiment but includes all changes and equivalent arrangements and substitutions included in the scope of the claims. When it is determined that a detailed description relating to a known function or configuration may render the purpose unnecessarily ambiguous in describing the particular embodiment, the detailed description will be omitted.

The terminology used herein is for the purpose of describing particular embodiments only and is not intended to be limiting of the disclosure. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

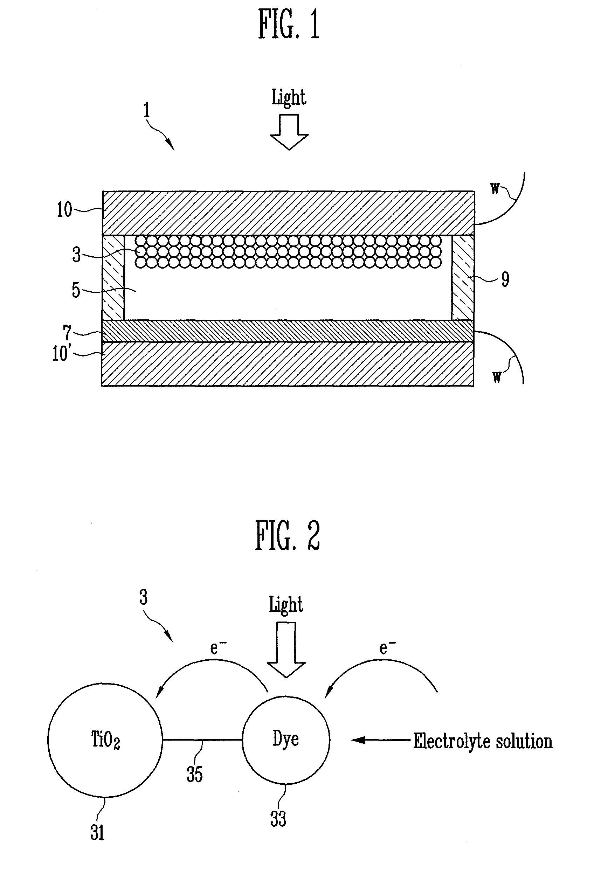

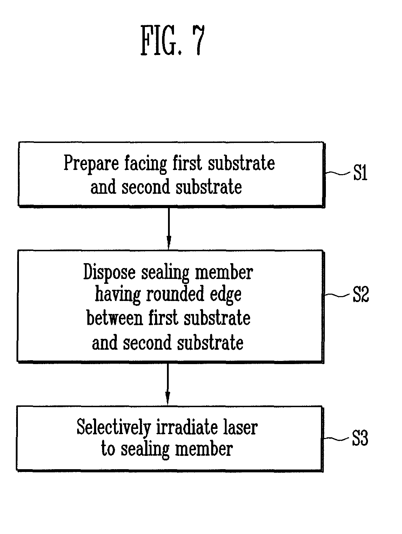

Hereinafter, exemplary embodiments will be described in detail with reference to the accompanying drawings. For example, a sealing member for a photoelectric conversion device, a photoelectric conversion device having the same, and a method of preparing the same according to exemplary embodiments are described with reference to FIGS. 1 to 7.

First, referring to FIGS. 1, 2 and 3A, the photoelectric conversion device 1 includes a first substrate 10, a second substrate 10' facing each other and a sealing member 9 joining the first substrate 10 and the second substrate 10' and sealing an electrolyte solution 5 in a space between the first substrate 10 and the second substrate 10', wherein an edge of the sealing member 9 includes round portions XY1, XY2, YX1, and YX2.

The first substrate 10 and the second substrate 10' are positioned to face each other with a predetermined distance. The first substrate 10 and the second substrate 10' may be formed of any suitable transparent material, which absorbs less light in a visible or a near-infrared region of light, such as sunlight, outside the photoelectric conversion device 1.

The first substrate 10 and the second substrate 10' may be formed of glass materials, such as quartz, typical glass, BK7 and lead glass, and resin materials, such as polyethylene terephthalate, polyethylene naphthalate, polyimide, polyester, polyethylene, polycarbonate, polyvinylbutyrate, polypropylene, tetra acetyl cellulose, syndiotactic polystyrene, polyphenylene sulfide, polyarylate, polysulfone, polyester sulfone, polyetherimide, cyclic polyolefin, brominated-phenoxy and vinyl chloride.

A transparent conductive layer 13, for example, a film of transparent conductive oxide (TCO), may be formed on at least the first substrate 10 through which light enters from the outside among the first substrate 10 and the second substrate 10'. Transparent conductive oxides may include, for example, any conductive material which less absorbs light in a visible or a near-infrared region of light outside the photoelectric conversion device 1. For example, the transparent conductive oxide may include metal oxides having an excellent conductivity including indium tin oxide (ITO), tin oxide (SNO₂) fluorine-doped tin oxide (FTO), antimony tin oxide (ITO/ATO), and zinc oxide (ZnO₂).

To improve photoelectric conversion efficiency, the first substrate 10 and the second substrate 10' may have a minimum sheet resistance, that is, a minimum surface resistance.

A first electrode 15 and a second electrode 15' may be formed on the first substrate 10 and the second substrate 10', respectively. In operation, the first electrode 15 and the second electrode 15' may function to transmit excited electrons to a drawn-out wire W, the excited electrons being transmitted through a metal oxide particle 31 to reach the first electrode 15 and the second electrode 15'. The first electrode 15 and the second electrode 15' are generally formed to prevent a phenomenon that generated current is converted into joule heat in a material having a comparatively low conductivity, such as in the transparent conductive layer 13, due to a high sheet resistance, which is about 10 Ω/sq or more, and photoelectric conversion efficiency decreases. Thus, the first electrode 15 and the second electrode 15' may be formed of high-conductive metal or an alloy thereof, for example, Ag, Ag/Pd, Cu, Au, Ni, Ti Co, Cr, Al, and the like.

Further, a protective layer 17 and 17' is, here, formed on the first electrode 15 and the second electrode 15'. In operation, the protective layer 17 and 17' may function to prevent or control corrosion of the first electrode 15 and the second electrode 15' by the electrolyte solution 5. The protective layer 17 and 17' is disposed on the transparent conductive layer 13, the first electrode 15, and the second electrode 15' to cover an exposed surface of the first electrode 15 and the second electrode 15', protecting the first electrode 15 and the second electrode 15' from being corroded by the electrolyte solution 5. Here, the protective layer 17 and 17' is formed by applying a glass paste composition having a low melting point to the expose surface of the first electrode 15 and the second electrode 15' and firing.

In the photoelectric conversion device 1, a photoelectrode layer 3 may be used as an inorganic metal oxide semiconductor film having a photoelectric conversion function. The photoelectrode layer 3 may be formed of a porous film.

As shown in FIGS. 1 and 2, the photoelectrode layer 3 may be formed by stacking a plurality of metal oxide particles 31 of TiO₂ on the first electrode 15, and the stacked metal oxide particles 31 form a porous body including nanometer-size pores in the layer, that is, a nano-porous layer. The photoelectrode layer 3 may be formed of the porous body including a plurality of fine pores to increase a surface area of the photoelectrode layer 3 and to electrically connect a large amount of sensitizing dye 33 to a surface of the metal oxide particles 31. Accordingly the photoelectric conversion device 1 may have high photoelectric conversion efficiency.

As shown in FIG. 2, the photoelectrode layer 3 includes a connector 35 disposed on the surface of the metal oxide particles 31 to connect the metal oxide particles 31 to the sensitizing dye 33, thereby producing the inorganic metal oxide semiconductor added photoelectrode layer 3. Here, the term "connect" denotes to "combine" the inorganic metal oxide semiconductor with the sensitizing dye chemically or physically, for example, through adsorption. Thus, the term "connector" herein includes a chemical functional group, an anchoring group, and an adsorption group. FIG. 2 shows one sensitizing dye 33 connected to the surface of one metal oxide particle 31, which is an example. To improve electric output of the photoelectric conversion device 1, the sensitizing dyes 33 may be connected to the surface of the metal oxide particles 31 as many as possible, and a plurality of sensitizing dyes 33 may cover the surface of the metal oxide particles 31 as extensively as possible. However, when the covering sensitizing dyes 33 increase in number, excited electrons may be recombined, but may not be emitted as electric energy due to interaction between adjacent sensitizing dyes 33. Thus, a coadsorption material, such as deoxycholic acid, may be used so that the sensitizing dyes 33 perform covering, maintaining a proper distance.

The photoelectrode layer 3 may be formed by stacking the metal oxide particles 31 having an average diameter of about 20 nm to about 100 nm in a plurality of layers. The photoelectrode layer 3 may have a thickness of several µm, preferably about 10 µm or less. When the thickness of the photoelectrode layer 3 is less than several µm, a large amount of light passes through the photoelectrode layer 3, and photoexcitation of the sensitizing dyes 33 may be insufficient, so that effective photoelectric conversion efficiency may not be obtained. When the thickness of the photoelectrode layer 3 is greater than several µm, a distance between a surface of the photoelectrode layer 3, that is, a surface in contact with the electrolyte solution 5, and an electrical conduction surface, that is, an interface between the photoelectrode layer 3 and the first electrode 15, is lengthened. Thus generated excited electrons may not be as effectively transmitted to the electrical conduction surface, and thus, conversion efficiency may be unsatisfactory.

Next, the metal oxide particles 31 and the sensitizing dyes 33 used for the photoelectrode layer 3 are further described below.

Although the inorganic metal oxide semiconductor generally has a photoelectric conversion function with respect to a particular wavelength of light, the sensitizing dyes 33 are connected to the surface of the metal oxide particles 31 to enable photoelectric conversion with respect to light from a visible-ray region to a near-infrared region of light. The metal oxide particles 31 may use any compound to connect the sensitizing dyes 33 and to have a sensitized photoelectric conversion function and may include, for example, titanium oxide, tin oxide, tungsten oxide, zinc oxide, indium oxide, niobium oxide, iron oxide, nickel oxide, cobalt oxide, strontium oxide, tantalum oxide, antimony oxide, lanthanide oxide, yttrium oxide, and vanadium oxide.

Here, since the surface of the metal oxide particles 31 become sensitized due to the sensitizing dyes 33, a conduction band of an inorganic metal oxide may be positioned to easily receive electrons from a photoexcited trap of the sensitizing dyes 33.

In preferred embodiments, compounds of the metal oxide particles 31 may be titanium oxide, tin oxide, zinc oxide, and niobium oxide. More preferred metal oxide particles 31 may include titanium oxide taking into account price and environmental issues.

The sensitizing dyes 33 are not limited to any particular dye. For example, the sensitizing dyes 33 may include any dye having a photoelectric conversion function with respect to light in a region where the metal oxide particles 31 do not have a photoelectric conversion function, for example, from a visible to a near-infrared region. The sensitizing dyes 33 may include azo dyes, quinacridone dyes, diketopyrrolopyrrole dyes, squarylium dyes, cyanine dyes, merocyanine dyes, triphenylmethane dyes, xanthene dyes, porphyrin dyes, chlorophyll dyes, ruthenium dyes, indigo dyes, perylene dyes, dioxadine dyes, anthraquinone dyes, phthalocyanine dyes, naphthalocyanine dyes, and derivatives thereof.

The sensitizing dyes 33 may include a functional group in the structure as the connector 35 to be connected to the surface of the metal oxide particles 31 so as to quickly transmit excited electrons of photoexcited dyes to the conduction band of the inorganic metal oxide. The particular functional group is not limited. The functional group may include any substituent to connect the sensitizing dyes 33 to the surface of the metal oxide particles 31 and to quickly transmit the excited electrons of the dyes to the conduction band of the organic metal oxide. For example, the functional group may include a carboxyl group, a hydroxyl group, a hydroxamic acid group, a sulfonyl group, a phosphonic acid group, and phosphate group.

A counterpart electrode layer 7 functions as a positive electrode of the photoelectric conversion device 1. The counterpart electrode layer 7 may be formed on the second substrate 10', on which the second electrode 15' is formed and may be positioned to face the first substrate 10 where the first electrode 15 is formed. Thus, the counterpart electrode layer 7 may be positioned between the two substrates 10 and 10', and may be formed of a film.

In some embodiments, the counterpart electrode layer 7 is disposed on the second electrode 15', facing the photoelectrode layer 3 in a region surrounded by the first electrode 15, the second electrode 15', and the sealing member 9. A conductive metal catalyst layer may be disposed on a surface of the counterpart electrode layer 7, that is, a surface facing the photoelectrode layer 3.

Examples of conductive materials used for the metal catalyst layer on the counterpart electrode layer 7 may include metal. For example, the metal may include white gold, gold, silver, copper, aluminum, rhodium and indium, metal oxides including indium tin oxide (ITO), tin oxide including fluorine-doped tin oxide, zinc oxide, conductive carbon materials, or conductive organic materials.

A thickness of the counterpart electrode layer 7 is not particularly limited. In some embodiments, the thickness of the counterpart electrode layer may be about 5 nm to about 10 µm.

Drawn-out wires W are, here, connected to the first electrode 15, where the photoelectrode layer 3 is formed, and the second electrode 7, respectively. A drawn-out wire W from the first electrode 15 and a drawn-out wire W from the counterpart electrode layer 7 are connected outside the photoelectric conversion device 1 to form a current circuit.

The first electrode 15 and the counterpart electrode layer 7 may be electrically isolated, being spaced away from each other at a predetermined interval and sealed by the sealing member 9. The sealing member 9 may be formed among a marginal area of the first electrode 15, and the second electrode 15'. The sealing member 9 may function to seal a space formed by the first electrode 15, the second electrode 15', and the counterpart electrode layer 7. The sealing member 9 may be formed of resin having a high sealing performance and a high corrosion resistance. The sealing member 9 may be formed of thermoplastic resin, photocurable resin, ionomer resin, glass frit, or the like.

The sealing member 9 of the present embodiment will be described further.

The space between the first electrode 15 and the counterpart electrode layer 7 accommodates the electrolyte solution 5 and is sealed by the sealing member 9. The electrolyte solution 5 includes, for example, an electrolyte, a medium, and additives.

Here, the electrolyte may use I₃⁻/I⁻ or Br₃⁻/Br^{- X} redox electrolytes. For example, the electrolyte may include a mixture of I₂ and iodides including LiI, NaI, KI, CsI, MgI₂, CaI₂, CuI, tetraalkylammonium iodide, pyridinium iodide, and imidazolium iodide, a mixture of Br₂ and bromides including LiBr, organic molten salts, or the like, but are not limited thereto.

The iodides and the bromides may be used solely or in a combination thereof.

Here, the electrolyte may preferably use a mixture of I₂ and iodides, for example, I₂ and LiI, pyridinium iodide, or imidazolium, but may not be limited thereto.

With respect to a concentration of the electrolyte solution 5, I₂ in the medium is about 0.01 M to about 0.5M, either or both of the iodides and the bromides (or a mixture of a plurality of compounds) may be about 0.1 M to about 15M.

The medium used for the electrolyte solution 5 may be a compound having an ion conductivity.

In operation in, the photoelectrode layer 3 including the metal oxide particles 31 and the sensitizing dyes 33 connected to the surface of the metal oxide particles 31 through the connector 35, as shown in FIG. 2, when light comes in contact with the sensitizing dyes 33 connected to the metal oxide particles 31, the sensitizing dyes 33 become excited and emit excited electrons through photoexcitation. The emitted excited electrons are transmitted to the conduction band of the metal oxide particles 31 through the connector 35. The excited electrons transmitted to the metal oxide particles 31 are transmitted to other metal oxide particles 31 to reach the first substrate 10 and the second substrate 10', and then are discharged out of the photoelectric conversion device 1 through the drawn-out wire W. The sensitizing dyes 33 which lack electrons due to the discharge of the excited electrons receive electrons provided from the counterpart electrode layer 7 through the electrolyte of I⁻/I₃⁻ or the like in the electrolyte solution 5 and return to electrical neutrality.

Hereinafter, the sealing member for the photoelectric conversion device, the photoelectric conversion device having the same, and the method of preparing the same according to the present embodiment are further described with reference to FIG. 1 and FIGS. 3A, 3B, 4A, 4B, 5A, 5B, 6A, 6B and 7.

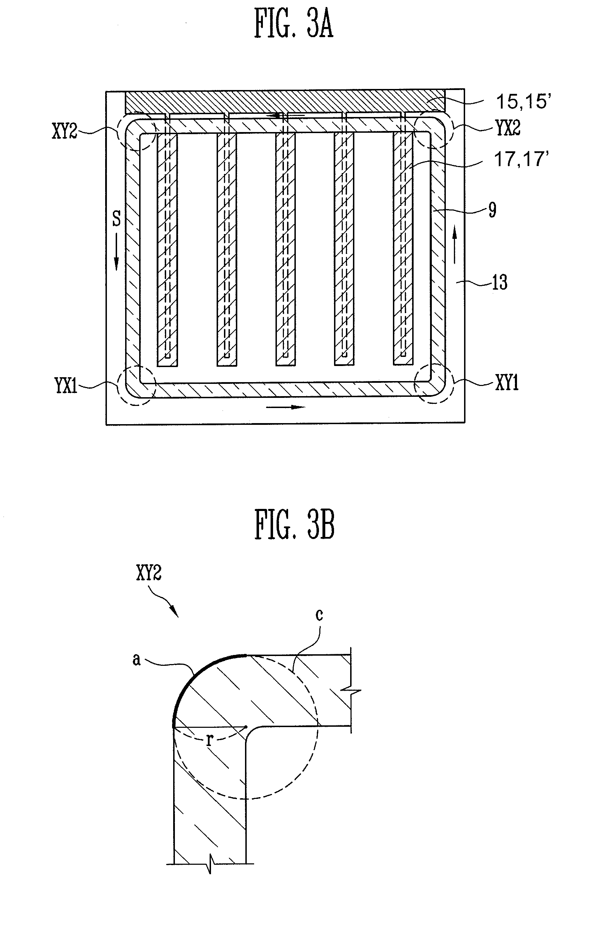

Referring to FIGS. 1 and 3A, the sealing member 9 for the photoelectric conversion device 1 connects the first substrate 10 and the second substrate 10' facing each other, and seals the electrolyte solution 5 in the space between the first substrate 10 and the second substrate 10'. Here, an edge of the sealing member 9 is formed to have a rounded portion XY1, XY2, YX1, and YX2. The sealing member 9 may be formed of at least one of a Bynel^{®} film and a Siren film.

Referring to FIG. 3B, assuming a circle c including a rounded portion XY2 as part of an arc a, a radius r of the circle c is formed to be about 50% or more of a width of the sealing member 9. Here, a thickness of the sealing member 9 may be about 50 µm to about 300 µm. When the radius r of the circle c is less than about 50% of the width of the sealing member 9, only an outer arc a exists along the radius, a length of an inner arc a becoming 0, in the rounded portion XY2. In this case, laser energy is accumulated more inwards, and accordingly the sealing member 9 becomes out of allowed processing conditions to cause unbalanced quality of the sealing member 9 between an inward side and an outward side in the rounded portion XY2.

As the radius of the rounded portion XY2 on the edge is lengthened, a difference in length between the inner arc a and the outer arc a decreases, and accordingly there becomes no quality difference of the sealing member 9 between the inward side and the outward side.

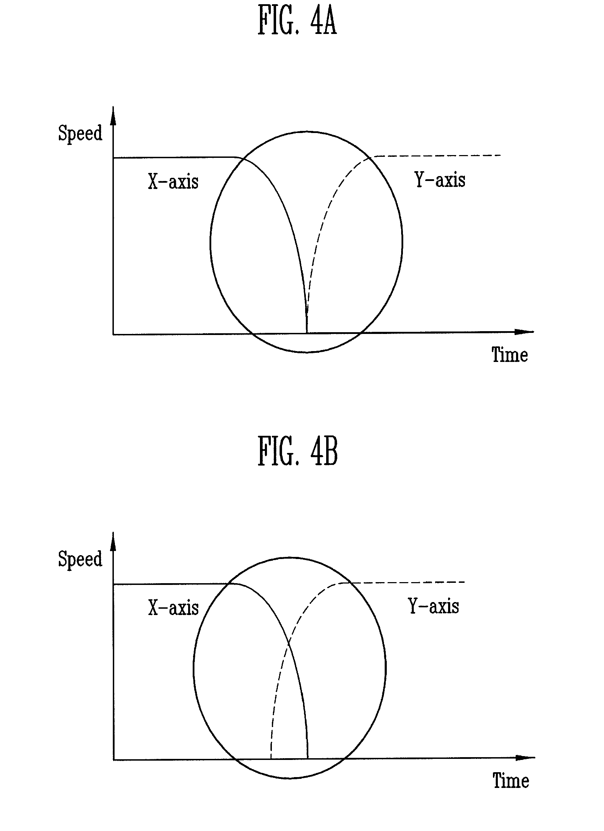

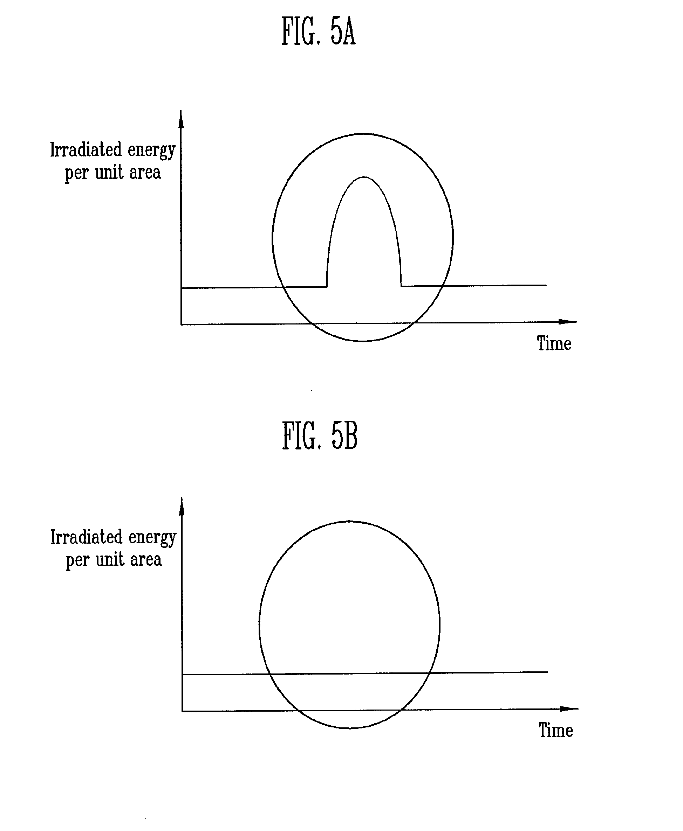

In a conventional sealing member having an angular edge according to a Comparative Example, as shown in FIG. 4A, when a laser proceeding direction S is changed from a y-axis to an x-axis (YX1 and YX2) and when the laser proceeding direction is changed from the x-axis to the y-axis,(XY1 and XY2) a laser proceeding speed decreases to 0. Further, as shown in FIG. 5A, laser energy is concentrated on the displayed edge portion.

However, in the sealing member 9 having the edge including the rounded portions XY1, XY2, YX1, and YX2 according to Examples 1 and 2, as shown in FIG. 4B, when the laser proceeding direction is changed from the y-axis to the x-axis (YX1 and YX2) and when the laser proceeding direction is changed from the x-axis to the y-axis,(XY1 and XY2) a range where the laser proceeding speed decreases becomes small, and the laser proceeding speed decreases less than in the Comparative Example. Further, as shown in FIG. 5B, laser energy is not concentrated but is uniform in the displayed rounded portions XY2, XY2, YX1, and YX2.

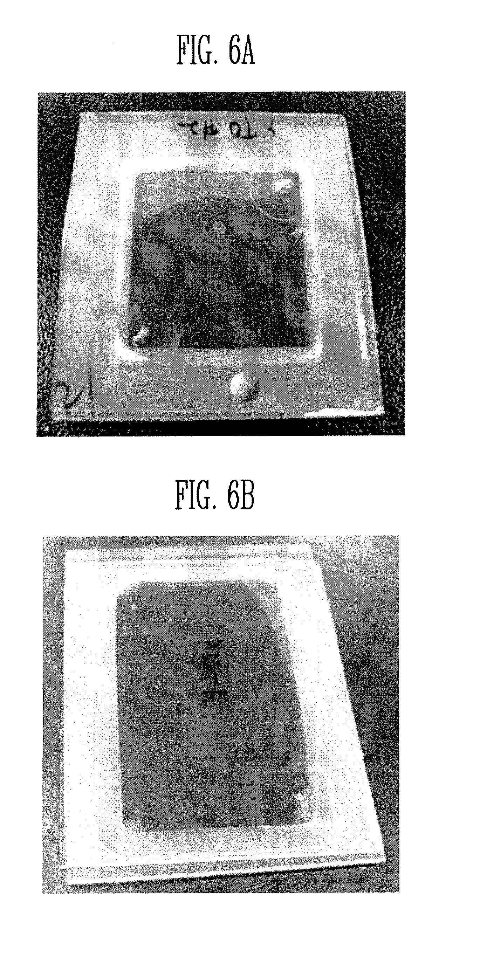

Referring to a photograph of the sealing member for a photoelectric conversion device according to the Comparative Example in FIG. 6A, air bubbles are formed in the sealing member, which decrease air-tightness. In a rectangular edge, to change a laser irradiation direction, a laser completely stops proceeding in one direction and then proceeds in a perpendicular direction. Accordingly, an accumulated amount of laser energy becomes greater in the edge where the speed is decreased or increased when the laser is irradiated, so that the sealing member is non-uniformly molten to decrease air-tightness. For example, when the laser power is reduced or the proceeding speed is increased, part of the sealing member does not melt. When the laser power is increased or the proceeding speed is reduced, part of the sealing member is excessively molten. Further, a method of simply maintaining irradiated energy per time uniformly by increasing the proceeding speed while increasing the laser power or by decreasing the proceeding speed while decreasing the laser power does not solely secure optimal sealing quality.

Referring to a photograph of the sealing member for the photoelectric conversion device according to the Example 1 in FIG. 6B, in a rounded edge, the laser power is uniform, and the speed is simultaneously decreased and increased when the laser is irradiated, and accordingly a speed element, that is, the proceeding speed, is uniform in a straight area and an edge area. Thus, an amount of laser energy accumulated in the edge is uniform to secure the same quality of airtightness in the entire sealing member.

Referring to FIGS. 1, 3A, 3B, and 7, the method of preparing the photoelectric conversion device 1 may include, for example, preparing the first substrate 10 and the second substrate 10' (S1), disposing the sealing member 9 between the first substrate 10 and the second substrate 10' (S2), and selectively irradiating a laser to the sealing member 9 (S3). Indeed, if the laser is irradiated on the inward side of the sealing member, a dye could be damaged and if the laser is irradiated on the outward side, a glass edge could be damaged.

Assuming a circle c including a round portion XY2 as part of an arc a, a radius r of the circle c is formed to be about 50% or more of a width of the sealing member 9. Here, a thickness of the sealing member 9 may be between about 50 µm and about 300 µm.

In the selectively irradiating the laser to the sealing member 9 of operation S3, laser irradiation is performed at a constant speed, and thus a uniform amount of energy is applied to a unit area.

### Examples

A first substrate 10 and a second substrate 10', facing each other, are prepared on a worktable (not shown). A sealing member 9 is disposed in a space theretween, sealing an electrolyte solution 5. Then, the first substrate 10 and the second substrate 10' are fastened using a pressing jig (not shown). Here, the pressing jig fastens the first substrate 10 and the second substrate 10' when traveling and applies a small pressure to properly join the sealing member 9 to the first substrate 10 and the second substrate 10' in a laser process. Then, a laser is irradiated, moving a head of an Nd-Yag laser (not shown) having a wavelength of 1064 nm. The worktable including the first substrate 10 and the second substrate 10' is maneuvered in an x-axis direction, and the laser head is maneuvered in a y-axis direction, and accordingly the sealing member 9 is joined in order in an S direction of FIG. 3A. A laser beam irradiates at a constant speed along a center line of the cut sealing member 9, moving the worktable and the laser head. Cutting conditions and laser joined conditions of the sealing member 9 are given in Table 1.

**Table 1**

| | Sealing member | | | | | Laser | |
|---|---|---|---|---|---|---|---|
| | Breadth (mm) | Length (mm) | Width (mm) | Thickness (µm) | Radius of circle including rounded portion (mm) | Proceeding speed (mm/s) | Power (W) |
| Example 1 | 90 | 50 | 3 | 260 | 5 | 1 | 28 |
| Example 2 | 91 | 51 | 2 | 260 | 3 | 1 | 16 |

According to the present disclosure, leakage of an electrolyte solution due to lowered adhesion of a sealing member or a wrinkled sealing member is reduced to improve reliability of a photoelectric conversion device. Further, uniform quality is secured in an entire region of a sealing member simply using a laser irradiation system, and thus performance needed for the system is eased to decrease a unit cost of a product. In addition, processing conditions are simplified to ease conditions needed for a sealing member, so that options of materials may become various.

While the present invention has been described in connection with certain exemplary embodiments, it will be appreciated by those skilled in the art that various modifications and changes may be made without departing from the scope of the present invention as claimed. It will also be appreciated by those of skill in the art that parts included in one embodiment are interchangeable with other embodiments; one or more parts from a depicted embodiment can be included with other depicted embodiments in any combination. For example, any of the various components described herein and/or depicted in the Figures may be combined, interchanged or excluded from other embodiments. With respect to the use of substantially any plural and/or singular terms herein, those having skill in the art can translate from the plural to the singular and/or from the singular to the plural as is appropriate to the context and/or application. The various singular/plural permutations may be expressly set forth herein for sake of clarity. Thus, while the present disclosure has described certain exemplary embodiments, it is to be understood that the disclosure is not limited to the disclosed embodiments, but, on the contrary, is intended to cover various modifications and equivalent arrangements included within the scope of the appended claims, and equivalents thereof.

## Claims

1. A sealing member (9) for a photoelectric conversion device joining a first substrate (10) and a second substrate (10') facing each other, and sealing an electrolyte solution (5) in a space between the substrates, **characterized in that** at least one edge of the sealing member (9) comprises a rounded portion (XY1, XY2, YX1, YX2), and a radius(r) of a circle (c) including the rounded portion is about 50% or more of the width of the sealing member.

2. The sealing member for the photoelectric conversion device of claim 1, wherein the rounded portion forms an outer arc (a) of circle and an inner arc of circle.

3. The sealing member for the photoelectric conversion device of Claim 1 or 2, wherein a thickness of the sealing member is between about 50 µm and about 300 µm.

4. The sealing member for the photoelectric conversion device of anyone of Claims 1 to 3, wherein the sealing member is formed of a MAH-g-HDPE film.

5. The sealing member for the photoelectric conversion device of anyone of Claims 1 to 4, wherein the sealing member is formed of a ethylene / metacrylic acid copolymer film.

6. A photoelectric conversion device, comprising:
a first substrate (10) and a second substrate (10'), wherein the substrates face each other; and
a sealing member as defined in anyone of claims 1 to 5.

7. A method of preparing a photoelectric conversion device, comprising:
preparing a first substrate and a second substrate, wherein the substrates face each other; and
joining the first substrate to the second substrate using a sealing member to seal an electrolyte solution therebetween, the sealing member including at least one rounded edge region,
wherein a radius of a circle including the rounded portion is about 50% or more of the width of the sealing member.

8. The method of claim 7, wherein the rounded portion forms an outer arc (a) of circle and an inner arc of circle.

9. The method of Claim 7 or 8, wherein a thickness of the sealing member is between about 50 µm and about 300 µm.

10. The method anyone of Claims 7 to 9, wherein joining of the first substrate to the second substrate comprises:
disposing the sealing member between the first substrate and the second substrate; and
selectively irradiating a laser to the sealing member.

11. The method of Claim 10, wherein the laser irradiation is performed at a constant speed.

12. The method of Claim 10, wherein in the selectively irradiating the laser, uniform energy per unit area is applied by the irradiation in the rounded portion.

13. The method of Claim 10, wherein the joining of the first substrate to the second substrate is performed by selective laser irradiation to the sealing member.

14. The method of Claim 13, wherein the laser irradiation in the rounded portion is performed at a constant speed.

15. The method of Claim 13, wherein uniform energy per unit area is applied by the irradiation in the rounded portion.
